# FASCICULE DE BREVET EUROPEEN

(11) **EP 4 082 052 B1**
(45) Date de publication et mention de la délivrance du brevet: **22.10.2025**
(21) Numéro de dépôt: 20851232.7
(22) Date de dépôt: 23.12.2020
(51) Int. Cl.: H10K 30/50, H10K 85/60, H10K 85/10

(54) **MODULE PHOTOVOLTAÏQUE**
FOTOVOLTAIKMODUL
PHOTOVOLTAIC MODULE

(30) Priorité: 24.12.2019 FR 1915542
(43) Date de publication de la demande: 02.11.2022
(73) Titulaire: Dracula Technologies, 26000 Valence (FR)
(72) Inventeur: BEN DKHIL, Sadok, 26000 Valence (FR); CRUCHON, Brice, 07500 Guilherand Granges (FR)
(74) Mandataire: Novagraaf Technologies
(86) Numéro de dépôt international: PCT/FR2020/052623
(87) Numéro de publication internationale: WO 2021/130461

(56) Documents cités:
- EP-A1- 2 960 957
- EP-A1- 3 227 933
- US-A1- 2016 322 566
- MALTE SCHULZ-RUHTENBERG ET AL: "Seminal Tools for Roll-to-Roll Manufacturing", LASER-TECHNIK-JOURNAL, 1 January 2014 (2014-01-01), pages 21 - 25, XP055742354, Retrieved from the Internet <URL:https://onlinelibrary.wiley.com/doi/abs/10.1002/latj.201400018> DOI: 10.1002/latj.201400018
- HUI SHI ET AL: "Effective Approaches to Improve the Electrical Conductivity of PEDOT:PSS: A Review", ADVANCED ELECTRONIC MATERIALS, vol. 1, no. 4, 1 April 2015 (2015-04-01), pages 1500017, XP055338405, ISSN: 2199-160X, DOI: 10.1002/aelm.201500017
- JIN YOUNG OH ET AL: "Effect of PEDOT Nanofibril Networks on the Conductivity, Flexibility, and Coatability of PEDOT:PSS Films", ACS APPLIED MATERIALS & INTERFACES, vol. 6, no. 9, 23 April 2014 (2014-04-23), US, pages 6954 - 6961, XP055742357, ISSN: 1944-8244, DOI: 10.1021/am500769k
- ANKE TEICHLER ET AL: "Inkjet printing of organic electronics - comparison of deposition techniques and state-of-the-art developments", JOURNAL OF MATERIALS CHEMISTRY C, vol. 1, no. 10, 1 January 2013 (2013-01-01), GB, pages 1910, XP055742358, ISSN: 2050-7526, DOI: 10.1039/c2tc00255h
- CHEN FANG-CHUNG: "Emerging Organic and Organic/Inorganic Hybrid Photovoltaic Devices for Specialty Applications: Low-Level-Lighting Energy Conversion and Biomedical Treatment", ADVANCED OPTICAL MATERIALS, vol. 7, no. 1, 8 October 2018 (2018-10-08), DE, pages 1800662, XP055793906, ISSN: 2195-1071, Retrieved from the Internet <URL:https://api.wiley.com/onlinelibrary/tdm/v1/articles/10.1002%2Fadom.201800662> DOI: 10.1002/adom.201800662
- ANONYMOUS: "PEDOT:PSS - Wikipedia", 16 August 2005 (2005-08-16), XP055796600, Retrieved from the Internet <URL:https://en.wikipedia.org/wiki/PEDOT:PSS> [retrieved on 20210419]

## Description

L'invention concerne de manière générale les modules photovoltaïques, et en particulier les modules photovoltaïques comprenant plusieurs cellules photovoltaïques organiques (usuellement désignées par l'acronyme anglais OPC pour « *Organic Photovoltaic Cells* »).

Par cellule photovoltaïque organique, on entend, au sens de la présente invention, une cellule photovoltaïque dont au moins la couche active est constituée d'un matériau organique.

Les modules photovoltaïques comprenant des cellules photovoltaïques organiques représentent un véritable intérêt dans le domaine du photovoltaïque. En effet, la possibilité de substituer les semi-conducteurs inorganiques généralement utilisés dans les cellules photovoltaïques, comme le silicium, le cuivre, l'indium, le gallium, le sélénium, ou encore le tellurure de cadmium, permet d'accroître le nombre de systèmes réalisables et donc les possibilités d'utilisation. Le développement des modules photovoltaïques commercialisables et comprenant plusieurs cellules photovoltaïques organiques représentent actuellement un enjeu majeur.

Ces dernières années, le développement des cellules organiques photovoltaïques a connu une évolution par l'utilisation de la technique d'impression par jet d'encre pour leur mise en oeuvre ^{[1],[2]}. D'ailleurs, le Demandeur a mis au point en 2014 un procédé de fabrication de cellules photovoltaïques utilisant cette technique pour l'impression d'une partie des couches de ces cellules ^{[3]}.

Dans un premier temps, de nombreuses études se sont focalisées sur la réalisation d'une couche interfaciale par impression par jet d'encre d'une encre comprenant un mélange polymère de poly(3,4-éthylènedioxythiophène) et de poly(styrène-sulfonate) de sodium, usuellement désigné par l'acronyme PEDOT:PSS. Puis, les recherches dans ce domaine se sont portées sur l'impression par jet d'encre de la couche active photovoltaïque, qui est usuellement composée de deux matériaux organiques, l'un donneur d'électrons et l'autre accepteur d'électrons. Pour une couche active de nature organique, on utilise classiquement le P₃HT:PCBM (P₃HT étant l'acronyme désignant le poly(3-hexylthiophène) et le PCBM étant l'acronyme désignant [6,6]-phényl-C₇₁-butanoate de méthyle).

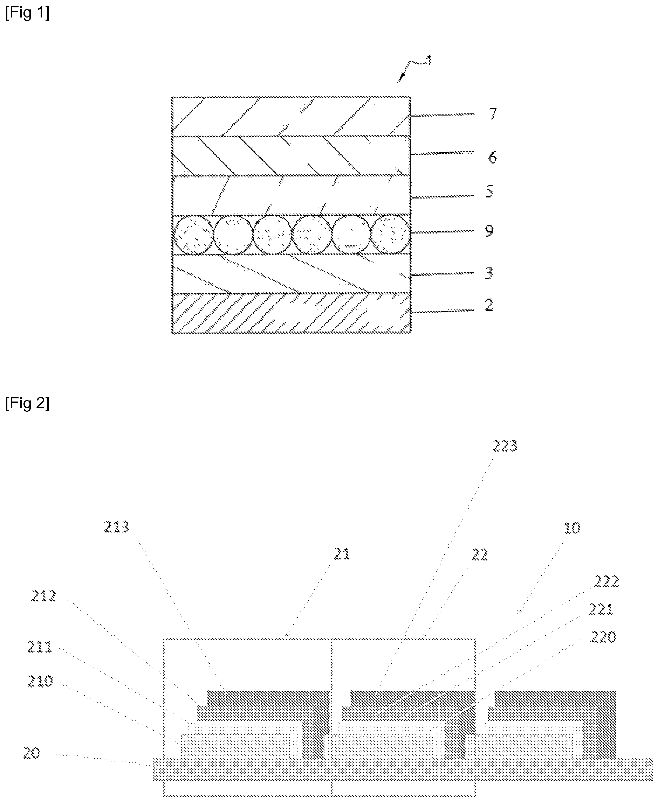

Comme illustré par la figure 1, dans une cellule photovoltaïque à structure normale ou classique actuellement utilisée 1, une première couche interfaciale 9, par exemple en PEDOT:PSS, est disposée sur une couche d'oxyde d'indium-étain 3 (généralement désigné par l'acronyme anglais ITO pour « *Indium Tin Oxide* ») qui sert ici d'anode et qui est elle-même appliquée sur un support. Au-dessus de la première couche interfaciale 9 est appliquée une couche active photovoltaïque 5 qui peut par exemple être à base de P₃HT:PCBM, et au-dessus de cette couche active photovoltaïque 5 est appliquée une deuxième couche interfaciale 6 au-dessus de laquelle est appliquée une électrode supérieure 7 opaque habituellement en aluminium, ou en argent lorsque cette couche est appliquée par impression à jet d'encre, et qui sert ici de cathode.

Il existe également actuellement des cellules photovoltaïques à structure inverse. La différence majeure par rapport à la structure classique est relative au fait que la couche interfaciale en PEDOTT :PSS est située entre la couche active et l'électrode supérieure qui est l'anode. Il est à noter que les cellules photovoltaïques à structure inverse présentent l'avantage d'avoir une meilleure stabilité à l'air que les cellules photovoltaïques à structure classique, et en outre de présenter généralement des rendements de conversion plus élevés.

Par rendement de conversion d'une cellule photovoltaïque, on entend, au sens de la présente invention, le rapport de la puissance électrique maximale délivrée par la cellule sur la puissance lumineuse incidente, pour une distribution spectrale et une intensité donnée.

Il est à noter, par ailleurs, que les rendements de conversion élevés ci-avant mentionnés sont assurés lorsque les modules photovoltaïques de l'état actuel de la technique sont exposés à un rayonnement extérieur, c'est-à-dire exposés à une intensité lumineuse supérieure à 2000 lux et en particulier à un rayonnement dans des conditions standards AM1.5 qui correspond à une intensité lumineuse d'exposition ayant une puissance de 100 mW/cm2 qui équivaut à une intensité lumineuse environ égale à 100000 Lux. En particulier, le nombre élevé de charges photo-générées nécessite l'utilisation d'une anode à très haute conductivité électrique pour garantir une bonne collecte de charges photo-générées dans la couche active de manière à minimiser, entre autres, le phénomène d'accumulation. En particulier, le nombre élevé de charges photo-générées nécessite l'utilisation d'une anode à très haute conductivité électrique pour garantir une bonne collecte, dans la couche active, de charges photo-générées de manière à minimiser le phénomène d'accumulation au niveau des couches interfaciales. C'est pourquoi généralement, dans le cas d'une structure inverse, l'électrode supérieure (ou anode) est opaque et en argent. Dans ce cas, le rendement de conversion peut atteindre, à l'échelle du laboratoire, des valeurs comprises entre 15 et 17 % pour les cellules photovoltaïques organiques. Cependant, lorsque l'on se trouve à une échelle industrielle, le rendement de conversion, cette fois-ci des modules photovoltaïque fabriqués, est divisé par deux ou plus.

Cependant, les modules photovoltaïques de l'état actuel de la technique ne permettent pas d'être efficacement utilisés sous un rayonnement intérieur, c'est-à-dire sous une puissance de 0.3 mW/cm², équivalent à 1000 lux.

Ce faible rendement de conversion, lorsqu'on les modules photovoltaïques sont exposés au rayonnement intérieur, est notamment dû au fait que les modules photovoltaïques comprenant des cellules photovoltaïques organiques de l'état actuel de la technique présentent une résistance série élevée liée aux nombre de couches formant la cellule photovoltaïque organique et donc le module photovoltaïque et des résistances shunt pas assez élevées, les résistances shunt continuant à diminuer avec la baisse de l'intensité lumineuse. Ces résistances ne permettent donc pas d'optimiser les performances et le facteur de remplissage des modules photovoltaïques organiques de l'état actuel de la technique. En effet, il est connu que la résistance shunt doit être suffisamment grande pour une meilleure puissance de sortie et un bon facteur de remplissage du module photovoltaïque. En effet, pour une faible résistance shunt, le courant s'effondre fortement ce qui signifie que la perte de puissance est élevée et le facteur de remplissage est faible.

Par ailleurs, le faible rendement de conversion des modules photovoltaïques de l'état actuel de la technique est également dû au fait qu'ils présentent des surfaces mortes élevées qui sont liées au fait que le dépôt des différentes couches constitutives de chacune des cellules photovoltaïques organiques des modules photovoltaïques sont appliquées sur le support en décalé, de sorte à ce que chaque couche de la cellule photovoltaïque organique soit en partie en contact avec le support afin d'éviter la création de courts circuits qui peuvent être provoqués par l'effet retour inverse du matériau déposé à l'état liquide par exemple. Par conséquent, les modules photovoltaïques de l'état actuel de la technique présentent des surfaces actives faibles ce qui ne permet pas de générer un photo-courant suffisant lorsque l'intensité lumineuse incidente est faible.

Malte Schulz-Ruhtenberg ET AL: "Seminal Tools for Roll-to-Roll Manufacturing", Laser-Technik-Journal, 1 janvier 2014 (2014-01-01), pages 21-25, XP055742354 divulgue un module photovoltaique comprenant une couche de poly(3,4-éthylènedioxythiophène) et poly(styrènesulfonate) poly(styrene-sulfonate) et une structure d'interconnexion préparée à l'aide d'un laser.

Hui Shi ET AL: "Effective Approaches to Improve the Electrical Conductivity of PEDOT:PSS: A Review", ADVANCED ELECTRONIC MATERIALS, vol. 1, no. 4, 1 avril 2015 (2015-04-01), page 1500017, XP055338405D2 fournit une revue des approches efficaces pour améliorer la conductivité électrique du PEDOT:PSS et mentionne des rapports antérieurs sur l'inclusion d'une structure fibreuse organique pour augmenter la conductivité de la couche de PEDOT:PSS.

Jin Zoung Oh ET AL: "Effect of PEDOT Nanofibril Networks on the Conductivity, Flexibility, and Coatability of PEDOT:PSS Films",ACS APPLIED MATERIALS & INTERFACES, vol. 6, no. 9, 23 avril 2014 (2014-04-23), pages 6954-6961, XP055742357 divulgue une cellule solaire comprenant une couche de PEDOT:PSS incluant une structure fibreuse organique.

US 2016/322566 A1 divulgue la fabrication et la caractérisation d'un module photovoltaïque organique inversé à grande échelle, fabriqué à l'aide d'un procédé de pulvérisation et comprenant une couche de poly(3,4-éthylènedioxythiophène) et poly(styrènesulfonate) poly(styrene-sulfonate).

Il n'existe donc pas, dans l'état actuel de la technique, de modules photovoltaïques organiques comprenant des cellules photovoltaïques organiques adaptées au rayonnement intérieur selon lequel l'intensité lumineuse incidente est limitée.

Ainsi, un des buts de l'invention est de remédier au moins en partie aux insuffisances des modules photovoltaïques, et de leur procédé de fabrication, de l'état de la technique.

Selon un premier aspect, l'invention concerne un module photovoltaïque comprenant :
- un support en verre ou en un matériau polymère,
- au moins deux cellules photovoltaïques, une première cellule photovoltaïque et une deuxième cellule photovoltaïque, sur ledit support, chacune desdites deux cellules photovoltaïques comprenant :
   i. une couche d'oxyde d'indium-étain constituant la cathode et recouvrant ledit support,
   ii. une première couche interfaciale d'oxyde de zinc ou d'oxyde de zinc dopé à l'aluminium, ladite première couche interfaciale recouvrant ladite cathode,
   iii. une couche active photovoltaïque recouvrant ladite première couche interfaciale, et
   iv. une deuxième couche interfaciale comprenant un mélange polymère de poly(3,4-éthylènedioxythiophène) et de poly(styrène-sulfonate) de sodium, ladite deuxième couche interfaciale constituant l'anode et recouvrant ladite couche active photovoltaïque, ladite deuxième couche interfaciale étant continue, présentant une structure fibreuse organique et une épaisseur moyenne comprise entre 100 nm et 400 nm,
la deuxième couche interfaciale de la première cellule photovoltaïque étant en contact avec la couche d'oxyde d'indium-étain de la deuxième cellule photovoltaïque.

Selon ce premier aspect, le module selon l'invention présente un rendement de conversion compris entre 14% et 21%, ce qui est suffisant pour pouvoir utiliser efficacement le module photovoltaïque sous un rayonnement intérieur. En particulier, avec le module photovoltaïque selon l'invention, les pertes de charges photo-générées sont minimisées, et leurs transferts entre les différentes couches des cellules photovoltaïques organiques sont améliorés de manière à avoir une stabilité générale du module photovoltaïque. En effet, la stabilité générale d'un module photovoltaïque organique dépend de la stabilité intrinsèque des différentes couches constituant chacune des cellules photovoltaïques organique du module photovoltaïque organique mais aussi de la stabilité des interfaces entre chacune de ces couches. Par ailleurs, avec le module photovoltaïque selon l'invention, en s'affranchissant de la couche d'argent comme anode et en ayant une unique couche utilisée comme deuxième couche interfaciale et anode, on a des cellules photovoltaïques organiques comprenant moins d'interfaces que dans celles utilisées dans l'état actuel de la technique. Par conséquent, le risque de perte des charges photo-générées est amoindri et le risque d'avoir une oxydation d'interfaces est également amoindrie.

Aussi, il est à noter que l'on utilise ici comme anode une couche comprenant un mélange polymère de poly(3,4-éthylènedioxythiophène) et de poly(styrène-sulfonate) de sodium et non une couche comprenant un matériau à haute conductivité classiquement employée pour jouer le rôle d'anode, comme une couche d'argent par exemple, car en appliquant directement la couche comprenant un matériau à haute conductivité sur la couche active photovoltaïque, il existe un risque de pénétration des particules (par exemple des nanoparticules métalliques d'argent) à base de ce matériau à haute conductivité à travers la couche active ; ce qui peut générer des courts-circuits.

Des réactions chimiques, en général l'oxydation, sont activées par la température et peuvent apparaitre au niveau de l'interface couche active/électrode métallique. Ce problème n'existe pas lorsque l'on applique une électrode constituée d'une couche comprenant un mélange polymère de poly(3,4-éthylènedioxythiophène) et de poly(styrène-sulfonate) de sodium sur la couche active.

Par ailleurs, il est déjà bien connu que pour le rayonnement intérieur, la résistance shunt est critique pour les performances des cellules photovoltaïques organiques notamment et c'est cette résistance qui limite le facteur de remplissage. Le module photovoltaïque selon l'invention présente alors une résistance shunt supérieure à celle des modules photovoltaïques de l'état actuel de la technique et une résistance série inférieure à celle des modules photovoltaïques de l'état actuel de la technique de manière à avoir un facteur de remplissage élevé et stable entre 50 et 1000 lux, en particulier comprise entre 65% et 73%.

Aussi, étant donné que le module photovoltaïque selon l'invention ne comprend pas de couche d'argent comme anode, ce module photovoltaïque présente une faible surface morte et une surface active plus élevée que dans les modules photovoltaïques de l'état de l'art.

Par surface morte, au sens de la présente invention, on entend la surface totale du module photovoltaïque qui tient compte de l'ensemble de couches déposées pour la fabrication de chacune des cellules photovoltaïques organiques constitutives du module photovoltaïque à laquelle on soustrait la surface active. La surface morte correspond à la surface qui correspond à la zone de l'interconnexion entre chacune des cellules photovoltaïques organiques, la zone d'interconnexion étant hors de la surface active.

Par surface active, au sens de la présente invention, on entend la surface commune aux différentes couches superposées et formant chacune des cellules photovoltaïques organiques constitutives du module photovoltaïque. La surface active comprend les électrodes et est donc délimitée par la surface des deux électrodes supérieure et inférieure.

En effet, le fait de s'affranchir de la couche d'argent comme anode permet d'appliquer des couches présentant une plus grande surface. Ainsi, la puissance du module photovoltaïque selon l'invention est améliorée et le photo-courant généré est augmenté. En particulier, avec le module photovoltaïque selon l'invention, on gagne entre 20 et 30% en surface active par rapport à la configuration des modules utilisant une couche d'argent comme anode. L'affranchissement de la couche d'argent comme anode, et la présence d'une telle deuxième couche interfaciale permet au module photovoltaïque selon l'invention de présenter un facteur de remplissage supérieur à 70%.

Aussi, le fait de s'affranchir de la couche d'argent comme anode présente l'avantage d'avoir un module comprenant moins d'interface, donc une meilleure stabilité et un coût de fabrication diminué par rapport aux modules de l'art antérieur comprenant notamment cette couche d'argent comme anode.

En outre, dans le module selon l'invention, la résistance série entre la deuxième couche interfaciale et la couche d'oxyde d'indium-étain est faible ce qui permet de garantir une bonne interconnexion entre les cellules.

De préférence, la deuxième couche interfaciale est transparente et présente un coefficient de transparence inférieur à 0.6. Ainsi, le coefficient d'absorption de photons du module est augmenté, et les performances du module sont ainsi améliorées.

De préférence, le support est transparent et la deuxième couche interfaciale comprenant un mélange polymère de poly(3,4-éthylènedioxythiophène) et de poly(styrène-sulfonate) de sodium est également transparente. Ainsi, il est possible de produire des charges photo-générées de part et d'autre du module photovoltaïque pour améliorer davantage le rendement de conversion de chacune des cellules photovoltaïques organique comprises dans le module photovoltaïque.

Dans un mode particulier de l'invention, dans des conditions classiques de rayonnement à savoir lorsque le module est exposé à un spectre solaire AM 1.5, le nombre de charges photo-générées par le module photovoltaïque selon l'invention est avantageusement limité par rapport aux modules photovoltaïques actuellement utilisés. Dans les modules photovoltaïques actuellement utilisés et comprenant des cellules photovoltaïques organiques à structure inverse, pour une bonne extraction de charges photo-générées et pour un bon fonctionnement du module, il est nécessaire d'avoir une électrode métallique supérieure à haute conductivité électrique en guise d'anode. Toutefois, les cellules photovoltaïques du module de l'invention ne comprennent pas cette électrode métallique. Dans l'invention, dans chaque cellule photovoltaïque, c'est la deuxième couche interfaciale qui joue le rôle d'anode et présente une conductivité électrique suffisante qui assure à la fois l'extraction des charges et leurs transferts vers les autres couches des cellules photovoltaïque lorsque le module photovoltaïque est exposé à un rayonnement intérieur (en général il s'agit d'un rayonnement inférieur ou égal à 1000 lux). Par conséquent, pour permettre au module photovoltaïque de fonctionner de manière optimale sous un rayonnement intérieur, dans ce mode de réalisation, les deuxièmes couches interfaciales présentent une résistance carrée comprise entre 100 Ω/□ et 600 Ω/□.

Dans un mode particulier de l'invention, le rendement de conversion est davantage amélioré. Par conséquent, dans ce mode de réalisation, les deuxièmes couches interfaciales présentent une rugosité Ra égale ou inférieure à 5 nm.

Dans un mode particulier de l'invention, les couches actives photovoltaïques comprennent un mélange de polymères comprenant du [6,6]-phenyl-C₆₁-butanoate de méthyle associé à du poly(thiéno[3,4-b]-thiophène.

Dans un mode particulier de l'invention, il est avantageux de pouvoir appliquer le module photovoltaïque sur différents objets et que ce module puisse s'y conformer. Par conséquent, dans ce mode de réalisation, le support est souple.

Selon un deuxième aspect, l'invention concerne une utilisation du module photovoltaïque ci avant décrit sur des produits de type équipement sportif léger, poussette, packaging, notamment de luxe, bagagerie, maroquinerie, décoration intérieur, électronique, panneau publicitaire sur lieu de vente, équipement de protection individuel, ganterie, jouet et loisir éducatif, mobilier, parasol, textile, cycle, automobile. L'invention concerne également une utilisation du module photovoltaïque ci-avant décrit sous un rayonnement égal ou inférieur à 1000 lux.

Selon un troisième aspect, l'invention concerne un procédé de fabrication d'un module photovoltaïque tel que défini ci-avant, comprenant les étapes suivantes :
a) fourniture d'un support en verre ou en un matériau polymère ;
b) réalisation sur ledit support de deux couches d'oxyde d'indium-étain, chacune desdites couches d'oxyde d'indium-étain constituant la cathode de chacune desdites cellules photovoltaïques ;
c) réalisation de deux premières couches interfaciales, chacune desdites deux premières couches interfaciales étant réalisée sur chacune desdites couches d'oxyde d'indium-étain ;
d) réalisation de deux couches actives photovoltaïques, chacune desdites couches actives photovoltaïques étant réalisée sur chacune desdites premières couches interfaciales ;
e) réalisation de deux deuxièmes couches interfaciales, chacune desdites deuxièmes couches interfaciales étant réalisée sur chacune desdites couches actives photovoltaïques et constituant l'anode de chacune desdites cellules photovoltaïques ;
le procédé étant caractérisé en ce que les étapes c) à e) sont chacune réalisées par dépôt de compositions d'encre par impression numérique à jet d'encre, suivie d'un traitement thermique, ladite composition d'encre utilisée dans l'étape e) comprenant un mélange polymère de poly(3,4-éthylènedioxythiophène) et de poly(styrène-sulfonate) de sodium.

Selon ce troisième aspect, il n'est pas nécessaire de procéder, pour la fabrication du module photovoltaïque selon l'invention, à un traitement thermique supérieur à 130°C actuellement mis en œuvre pour recuire généralement la couche d'argent, ou des couches similaires utilisées comme anodes dans les cellules photovoltaïques organiques à structure inverse notamment. Le fait de s'affranchir d'un traitement thermique a pour l'avantage de ne pas altérer les autres couches des cellules photovoltaïques organiques par une montée en température contraignante. Ainsi, on peut notamment utiliser des modules photovoltaïques comprenant notamment des supports présentant des températures de transition vitreuse inférieure à 130°C.

Dans un mode particulier de l'invention, pour diminuer davantage les résistances séries entre chacune des couches des cellules photovoltaïques organiques. Par conséquent, dans ce mode de réalisation, on réalise entre les étapes d) et e) un nettoyage des couches actives photovoltaïques à l'aide d'un solvant choisi parmi l'éthanol, le butanol, le méthanol, l'isopropanol et l'éthylène glycol.

Dans un mode particulier de l'invention, on préfère mettre en œuvre un procédé de fabrication rapide, économique, stable et facilement reproductible. Par conséquent, dans ce mode de réalisation, étapes c) à e) sont réalisées comme suit :
c) dépôt par impression numérique à jet d'encre sur chacune des deux couches d'oxyde d'indium-étain d'une première composition d'encre comprenant des nanoparticules d'oxyde de Zinc ou des nanoparticules d'oxyde de zinc dopé à l'aluminium (AZO), puis traitement thermique, pour former les deux premières couches interfaciales ;
d) dépôt par impression numérique à jet d'encre sur les deux premières couches interfaciales d'une deuxième composition d'encre comprenant un mélange de polymères comprenant du [6,6]-phenyl-C₆₁-butanoate de méthyle associé à du poly(thiénol[3,4-b]-thiophène) pour former les deux couches actives photovoltaïques ; et
e) dépôt par impression numérique à jet d'encre sur les deux couches actives photovoltaïques d'une troisième composition d'encre comprenant un mélange polymère de poly(3,4-éthylènedioxythiophène) et de poly(styrène-sulfonate) de sodium , puis traitement thermique, pour former les deux deuxièmes couches interfaciales.

Aussi, dans ce mode de réalisation, de préférence les traitements thermiques des étapes c) à e) sont des traitements de recuit réalisés à une température comprise entre 70°C et 130°C, pendant une durée comprise entre 1 et 5 minutes.

De préférence, dans ce mode de réalisation :
- le traitement thermique de l'étape c) est réalisé sur une plaque chauffante à une température de 85°C pendant 3 minutes ;
- le traitement thermique de l'étape d) est réalisé sur une plaque chauffante à une température de 85°C pendant 2 minutes ; et
- le traitement thermique de l'étape e) est réalisé sur une plaque chauffante à une température de 120°C pendant 1 à 5 minutes.

De préférence, dans ce mode de réalisation, l'étape b) de réalisation des deux couches d'oxyde d'indium-étain est réalisée par dépôt sous vide.

Actuellement, les réactions chimiques en présence de l'oxygène et de vapeur d'eau peuvent dégrader les performances des modules photovoltaïques et générer ce qu'on appelle le S-Shape qui se traduit par une dégradation importante du facteur de remplissage du module photovoltaïque. Par conséquent, à l'aide du procédé selon l'invention et dans un mode particulier de l'invention, les étapes c) à e) de dépôts par impression numérique à jet d'encre sont réalisées sous atmosphères à air ambiant.

De préférence, il est à noter que l'étape e) de dépôt par impression numérique à jet d'encre d'une troisième composition d'encre peut être réalisée par le dépôt d'une encre présentant une viscosité inférieure à 10 mPa.s à 20°C et comprenant :
- entre 90% et 98% en volume par rapport au volume total de la composition d'une solution de Poly(3,4-ethylènedioxythiophene)-poly(styrènesulfonate) de sodium, et
- entre 2% et 10% en volume par rapport au volume total d'une composition d'additifs comprenant :
   ∘ entre 2% et 5% en volume par rapport au volume total de l'ensemble des additifs de la composition d'additifs d'un tensioactif,
   ∘ entre 0,8% et 2% en volume par rapport au volume total de l'ensemble des additifs de la composition d'additifs d'éthylène glycol,
   ∘ entre 0.4% et 1% en volume par rapport au volume total de l'ensemble des additifs de la composition d'additifs éthanolamine, et
   ∘ entre 0,8% et 2% en volume par rapport au volume total de l'ensemble des additifs de la composition d'additifs d'un glycérol.

D'autres avantages et particularités de la présente invention résulteront de la description qui va suivre, faite en référence aux figures annexées et aux exemples suivants :
[Fig 1] représente une vue schématique en coupe d'une cellule photovoltaïque de structure classique ;
[Fig 2] représente une vue schématique en coupe d'un module photovoltaïque comprenant des cellules photovoltaïques selon un mode particulier selon l'invention ;
[Fig 3] représente une comparaison entre un module comprenant des cellules photovoltaïques de l'état actuel de la technique et un module photovoltaïque comprenant des cellules photovoltaïques selon un mode particulier selon l'invention ; et
[Fig 4] représente une vue schématique de dessus d'un module photovoltaïque comprenant des cellules photovoltaïques selon un mode particulier selon l'invention.

La figure 1 est décrite dans la présentation de l'art antérieur qui précède, tandis que les figures 2 à 4 sont décrites plus en détail au niveau des exemples qui suivent, qui illustrent l'invention sans en limiter la portée. Il est noté que l'invention est exposée dans le jeu de revendications annexé.

### EXEMPLES

### Produits

- support 20 en verre revêtu d'une couche d'oxyde d'indium-étain discontinue de manière à ce que le support soit en partie recouvert de couches d'oxyde d'indium-étain 210 et 220 qui vont former les cathodes des différentes cellules photovoltaïques organiques 21 et 22 ci-après décrites
- support 20 flexible en PET (Polyéthylène téréphtalate) ou en PEN (Polyéthylène (poly(éthylène 2,6-naphthalate) également revêtu d'une couche d'oxyde d'indium-étain discontinue de manière à ce que le support soit en partie recouvert de couches d'oxyde d'indium-étain 210 et 220 qui vont former les cathodes des différentes cellules photovoltaïques organiques 21 et 22 ci-après décrites
- solvants de nettoyage :
   ∘ dans le cas des supports rigides en verre : eau déionisée, Acétone, Ethanol, Isopropanol, et
   ∘ dans le cas des substrats flexibles, ces derniers étant protégés par des films en plastiques, ils n'ont pas besoin d'un nettoyage comme dans le cas des substrats rigides ;
- premières compositions d'encres (premières couches interfaciales 211 et 221 des cellules photovoltaïques 21 et 22 du module photovoltaïque 10 de la figure 2)
   ∘ encre E11 de nanoparticules d'oxyde de Zinc synthétisées en laboratoire et dont la formulation est détaillée à l'exemple 1.
   ∘ encre E12 de nanoparticules d'oxyde de Zinc dopé à l'aluminium (AZO) commercialisées par la société GENES'INK et synthèse réalisée en laboratoire.
- deuxièmes compositions d'encres (couches actives photovoltaïques 212 et 222 des cellules photovoltaïques 21 et 22 du module photovoltaïque 10 de la figure 2) :
   ∘ mélange polymère E21 de [6,6]-phenyl-C₇₁-butanoate de méthyle (commercialisé par Nano-C^{®} sous la dénomination commerciale PC70BM) et de poly(thiénol[3,4-b]-thiophène (commercialisé par Raynergy Tek^{®} sous la dénomination commerciale PV2000) ;
   ∘ mélange polymère E22 de [6,6]-phenyl-C₇₁-butanoate de méthyle (commercialisé par Nano-C^{®} sous la dénomination commerciale PC70BM) et de poly(thiénol[3,4-b]-thiophène (commercialisé par 1-Materials sous la dénomination commerciale PTB7-Th) ;
   ∘ O-xylène à titre de solvant (ortho-xylène de formule C₆H₄(CH₃)₂) ; et
   ∘ Tétraline (1,2,3,4-tétrahydronaphthaline) à titre d'additif.

Le polymère PV2000 du mélange E21 ou le polymère PTB7-Th du mélange E22 sont présents dans ces deuxièmes compositions d'encres à raison de 10 mg/ml.

Le rapport massique entre le polymère PV2000 du mélange E21 ou le polymère PTB7-Th du mélange E22 et le PC70BM est de 1:1.5

Le Rapport volumique entre le solvant O-xylène et l'additif Tétraline est de 97 : 3 dans ces deuxièmes compositions.

On réalise une deuxième composition d'encre en ajoutant au mélange polymère E21 ou E22 le solvant et l'additif et en maintenant ce mélange 24 heures sous agitation sur plaque chauffante à 80 °C à une vitesse de 700 RPM.
- troisièmes compositions d'encres (deuxièmes couches interfaciales 213 et 223 des cellules photovoltaïques 21 et 22 du module photovoltaïque 10 de la figure 2) :
   ∘ PEDOT:PSS commercialisé par Agfa^{®} sous la dénomination commerciale IJ1005 ou PEDOT : PSS commercialisé par Agfa^{®} sous la dénomination commerciale ORGACON S315 ;
   ∘ Triton X-100 (4-(1,1,3,3-tétraméthylbutyl)phényl-polyéthylène glycol de formulet-Oct-C₆H₄-(OCH₂CH₂)ₓOH, x= 9-10) commercialisé par Merck^{®} à titre de détergent/tensioactif ;
   ∘ Ethanediol (ou éthylène glycol, de formule HOCH2CH2OH) commercialisé par Merck^{®} ;
   ∘ glycérol (1,2,3-Propanetriol ou glycérine, de formule HOCH₂CH(OH)CH2OH) commercialisé par Merck^{®} ;
   ∘ Eau déionisée, produite en laboratoire ou bien commercialisée par la société PURELAB^{®} classic sous la marque ELGA^{®} pour l'eau.

### Tests

### • Mesure de la rugosité Ra

Ces mesures sont réalisées à l'aide d'un microscope à force atomique (Nanoscope III Multimode SPM de Brucker^{®}, utilisé en mode contact intermittent (ou « *tapping mode* »), avec des pointes hq:nsc15 commercialisées par MiKromasch^{®} et présentant un rayon de courbure 8 nm), les mesures ont été effectuées sur différents échantillons de cellules photovoltaïques selon l'invention et selon l'art antérieur.

### • Mesure de l'épaisseur des couches

La mesure de l'épaisseur des couches imprimées est effectuée au moyen d'un profilomètre à pointe de marque DektakXT commercialisé par BRUKER à partir d'une rayure faite avec une lame de cutter (on crée ainsi un canal ayant l'épaisseur du dépôt). Il s'agit d'un profilomètre de contact qui mesure des variations de relief grâce au déplacement vertical d'un stylet à pointe qui balaye la surface en appliquant une force de contact constante et en révèle toutes les dénivellations. L'échantillon est placé sur un plateau qui lui permet de se déplacer avec une vitesse donnée et sur une distance choisie. Les valeurs d'épaisseur présentées dans la présente demande de brevet correspondent à la moyenne de cinq mesures effectuées en six points différents d'une même marche d'un échantillon. Avant de réaliser les mesures, la longueur de la zone balayée, sa durée, la force d'appui du stylet et la plage de mesure doivent être définies.

### • Mesure de la résistivité électrique

Cette mesure est réalisée à l'aide de la technique 4 pointes, de la manière suivante :
- on place les 4 pointes alignées loin des bords de la couche à caractériser ;
- ces 4 pointes sont équidistantes les unes des autres ; et
- du courant est généré par un générateur de courant entre les pointes extérieures, tandis que la tension est mesurée entre les pointes intérieures. Le rapport de la tension mesurée sur l'intensité qui traverse l'échantillon donne la résistance du tronçon entre les pointes intérieures.

### • Mesure de la viscosité :

La viscosité d'un fluide se manifeste par sa résistance à la déformation ou bien au glissement relatif de ses couches. Au cours de l'écoulement d'un fluide visqueux dans un tube capillaire par exemple, la vitesse des molécules (v) est maximale dans l'axe du tube et diminue jusqu'à s'annuler à la paroi tandis qu'entre les couches se développe un glissement relatif ; d'où l'apparition de forces tangentielles de frottement. Les forces tangentielles, dans les fluides, dépendent de la nature du fluide considéré et du régime de son écoulement.

Le viscosimètre utilisé est de type *Ubbelhode,* il est placé dans un thermostat maintenu à température constante (25 °C dans notre cas d'étude). On mesure le temps d'écoulement d'un volume constant V défini par deux traits de repères (M1 et M2) situés de part et d'autre d'un petit réservoir surmontant le capillaire.

### • Mesure du vieillissement :

Vieillissement sous éclairage permanent de type « light soacking » et vieillissement thermique à 85°C

### • Caractérisation de la morphologie :

Mesures AFM (acronyme anglais pour « *Atomic Force Microscope* » : microscope à force atomique) pour reproduire la topographie de surface et TEM (acronyme anglais pour « *Transmission Electron Microscopy* » : microscope électronique en transmission) pour valider le caractère cristallin des matériaux ainsi que les tailles de nanoparticules présentes au niveau des couches.

### • Rendement de conversion

Le rendement de conversion est le rapport de la puissance générée et de la puissance du rayonnement incident sous un rayonnement intérieur. Le banc de mesure intérieur consiste à une enceinte isolée dans laquelle on réalise les caractérisations des cellules et des modules photovoltaïques organiques. On utilise un spectromètre qui permet de mesurer le flux lumineux incident (provenant de différentes sources de lumière comme des lampes LEDs, néons, halogènes et fluocompactes (en W/m² et en Lux). Les mesures sont aussi réalisées à l'aide d'un source-mètre Keithley 2450 (20mV - 200V, 10nA - 1A).

### EXEMPLE 1 : obtention d'un premier exemple de première composition d'encre E11 pour première couche interfaciale 211 et 221

### 1.1. Synthèse du ZnO par la technique Polyol^{[4]}

### Matériels utilisés:

Deux ballons, Colonne à Brome, Bain d'huile, Bouteille d'Argon, filtre à seringue, plaque chauffante et agitateur magnétique, bain à ultrason, imprimante Ardeje A100^{®}, imprimante Ardeje OD1000, tête d'impression des marques : KONICA^{®}, RICOH^{®}.

### Procédure:

- En premier lieu, on pèse une quantité de 2,207 g de KOH dans un ballon de 250 mL. Ensuite on ajoute 115 mL de méthanol. Dans un autre ballon plus grand, on ajoute 4.101g de l'acétate de zinc avec 210 mL de méthanol sous agitation puis on ajoute 115 ml d'eau.
- Puis, on fixe ce grand ballon dans un bain d'huile (ou d'eau) sous agitation et sous argon à 60°C sur une plaque chauffante et sous agitation.
- Par ailleurs, le KOH est dissous dans un bain ultrason pour l'ajouter ensuite goutte à goutte dans ce ballon.
- Nous observerons un changement de couleur de transparent à opaque. Après quelques minutes, la solution redevient transparente.
- Le mélange est ensuite encore agité pendant 3 heures, à l'issue desquelles une suspension blanche de ZnO s'est formée.

### 1.2 Fabrication de l'encre E11 à partir des nanoparticules de ZnO synthétisées

- L'oxyde zinc ZnO obtenu à l'issue de la technique Polyol à l'issue de l'exemple 1.1 est refroidi en bain froid et les particules de ZnO sont séparées par centrifugation (12 min et 7800 tr/ min) puis dispersées dans le butanol utilisant l'éthylène glycol comme surfactant.
- On obtient une encre E11 de particules de ZnO ayant une concentration en nanoparticules de 4 mg/ml.
- Avant l'impression par jet d'encre, l'encre E11 est préalablement filtrée avec un filtre de 0.45 micromètres en acétate de cellulose (AC).

### EXEMPLE 2 : obtention d'un deuxième exemple de première composition d'encre E12 pour première couche interfaciale 211 et 221

On utilise l'encre de nanoparticules d'oxyde de Zinc dopé à l'aluminium (AZO) commercialisée par la société GENES'INK^{®} de la manière suivante : avant l'impression par jet d'encre, l'encre est préalablement mise dans un bain ultrason pendant 2 minutes à température ambiante, puis filtrée avec un filtre de 0.45 micromètres en acétate de cellulose. On obtient l'encre E12.

### EXEMPLE 3 : obtention d'un troisième exemple de première composition d'encre E13 pour première couche interfaciale 211 et 221

### 3.1 Synthèse de nanoparticules d'AZO

Cette synthèse se fait par le protocole suivant, conformément à celui décrit dans la publication scientifique ^{[3]} :
- On introduit de l'acétate de zinc, de l'isopropylate d'aluminium et de l'eau distillée dans un ballon contenant de l'éthanol anhydre.
- Après chauffage à 80°C pendant 30 minutes, de l'hydroxyde de potassium dispersé dans l'éthanol est ajouté goutte à goutte au ballon en chauffant à 80°C pendant 16 heures : des nanoparticules d'AZO sont ainsi synthétisées.
- Ces nanoparticules sont ensuite séparées de la solution par centrifugation et dispersées dans un solvant à base d'alcool utilisant l'éthanolamine (EA).
- Par cette méthode, des nanoparticules d'AZO NCs (acronyme anglais pour: « *Aluminium Doped Zinc Oxyde nano-crystals* ») à des niveaux de dopage Al allant de 0% (référence non dopée) jusqu'à 0.8 at% ont été produites en variant le rapport initial du précurseur d'isopropylate d'aluminium par rapport à l'acétate de zinc, et en gardant tous les autres paramètres constants.

### 3.2 Procédure de fabrication de l'encre E12 à partir des nanoparticules d'AZO synthétisées

- L'AZO obtenu à l'issue de la technique Polyol à l'issue de l'exemple 3.1 est refroidi en bain froid et les particules d'AZO sont séparées par centrifugation (12 min et 7800 tr/ min) puis dispersées dans le butanol utilisant l'éthylène glycol comme surfactant.
- On obtient une encre E12 de particules d'AZO ayant une concentration en nanoparticules de 2 mg/ml.
- Avant l'impression par jet d'encre, l'encre E12 est préalablement filtrée avec un filtre de 0.45 micromètres en acétate de cellulose.

### EXEMPLE 4 : obtention de deuxièmes compositions d'encre E21 et E22 pour couche active photovoltaïque 212 et 222

Selon que l'on utilise du PC70BM associé à PV2000 ou du PC70BM associé à du PTB7-Th, on obtient respectivement les compositions d'encre E21 et E22, dont les compositions sont détaillées dans le tableau 1 ci-après :

**[Table 1]**

| Composition | E21 | E22 |
|---|---|---|
| PC70BM | 15 mg | 15 mg |
| PTB7-Th | 10 mg | |
| PV2000 | | 10 mg |
| O-xylène | 1 mL | 1 mL |
| Tétraline | 60 microlitres | 60 microlitres |

La composition d'encre E21 est obtenue comme suit :
- 10 mg PTB7-th mélangés avec 15 mg de PC70BM (correspondant à un rapport massique 1 :1.5) dans 1 millilitre de o-xylène et 60 microlitres de tétraline.
- Le mélange est mis sous agitation magnétique sur plaque chauffante à 80°C pendant 24 heures.
- Avant l'impression, l'encre est préalablement filtrée avec un filtre 0.45 micromètres en AC.
- Les couches imprimées subissent ensuite un recuit thermique sur plaque chauffante à 85 °C pendant 2 minutes.

La composition d'encre E22 est obtenue comme suit :
- 10 mg PV2000 mélangés avec 15 mg de PC70BM (correspondant à un rapport massique 1 : 1.5) dans 1 millilitre de o-xylène et 60 microlitres de tétraline.
- Le mélange est mis sous agitation magnétique sur une plaque chauffante à 80°C pendant 24 heures.
- Avant l'impression par voie jet d'encre, l'encre E22 est filtrée avec un filtre 0.45 micromètres en AC.
- Après impression jet d'encre d'E12 ou E22, on obtient des couches actives photovoltaïques qui, une fois imprimées sont soumises à un recuit thermique sur plaque chauffante à 85 °C pendant 2 minutes.

### EXEMPLE 5 : obtention de troisièmes compositions d'encre E31 et E32 pour deuxième couche interfaciale 213 et 223

Ces troisièmes compositions d'encre E31 et E32 pour deuxième couche interfaciale 213 et 223 sont obtenues comme suit :
- on filtre le PEDOT:PSS avec un filtre 0.45 µm ;
- on mélange 500 µl de Triton X-100 (a) avec 200 µl Ethylène Glycol (b), 200 µl Glycérol (c) et 100 µl Ethanolamine (d) dans 9 ml d'eau déionisée (e) ;
- on met le mélange ainsi obtenu sous agitation magnétique à 50°C sur plaque chauffante pendant 30 minutes, puis sous agitation magnétique à température ambiante pendant 20 minutes ;
- on mélange le PEDOT:PSS initialement filtré avec mélange ainsi obtenu après agitation, dans les proportions suivantes : 30 µl de mélange des 3 additifs dans l'eau déionisée pour 1 ml de PEDOT:PSS ; on met le mélange résultant (avec PEDOT:PSS) sous agitation magnétique sur plaque chauffante à température ambiante pendant 1 heure au minimum ; et
- on dégaze la solution finale ainsi obtenue E31 pendant 3 à 5 minutes dans un bain ultrason avant l'impression.

Selon que l'on utilise le PEDOT: PSS IJ1005 ou le PEDOT:PSS ORGACON S315, on obtient respectivement les compositions d'encre E31 et E32, dont les compositions sont détaillées dans les deux tableaux 2 et 3 ci-après :

**[Table 2]**

| Composition | | Solution X (a+b+c+d) |
|---|---|---|
| a-Triton x-100 | a | 500 µL |
| b-Ethylène Glycol | b | 200 µL |
| c-Glycérol | c | 200 µL |
| d-Ethanolamine | d | 100 µL |
| e-Eau déionisée | e | 9 mL |

**[Table 3]**

| Composition | E31 | E32 |
|---|---|---|
| IJ1005 | 1 mL | |
| Orgacon S315 | | 1 mL |
| Solution X a)+b)+c)+d) | 30 µL | 30 µL |

### EXEMPLE 6 : obtention d'exemples de modules photovoltaïques selon l'invention

On réalise des cellules OPV conformes à l'invention selon le procédé suivant :
Cas des substrats rigides :
- Nettoyage du substrat rigide en verre avec couche ITO structurée par trempage successif dans 4 bains de nettoyage différents :
   ∘ Bain 1 : Eau déionisée à 20-40 °C pendant 10-15 minutes,
   ∘ Bain 2 : Acétone à 20-40 °C pendant 10-15 minutes,
   ∘ Bain 3 : Ethanol à 20-40 °C pendant 10-15 minutes,
   ∘ Bain 4 : Isopropanol à 20-40 °C pendant 10-15 minutes ;
- Impression de l'encre E11, E12, ou E13 sur chacune des couches d'oxyde d'indium-étain 210 et 220 suivi d'un recuit à 85 °C pendant 5 minutes pour obtenir les premières couches interfaciales 211 et 221;
- Impression de l'encre E21 ou E22 sur chacune des premières couches interfaciales 211 et 221 suivi d'un recuit à 85 °C pendant 2 minutes pour obtenir la couche active 212 et 222 ;
- Nettoyage de la couche active 212 et 222 avec un alcool (Ethanol, Butanol, isopropanol) ;
- Impression de l'encre E31 ou E32 sur chacune des couches actives 212 et 222, suivi d'un recuit à 120 °C pendant 2 minutes de manière à avoir une deuxième couche interfaciale 213 et 223 présentant une épaisseur comprise entre 100 et 400 nm, en particulier environ égale à 350 nm, la deuxième couche interfaciale 213 de la première cellule photovoltaïque 21 étant en contact avec la couche d'oxyde d'indium-étain 220 de la deuxième cellule photovoltaïque 22;
- Nettoyage de la deuxième couche interfaciale 213 et 223 avec un alcool (Ethanol, Butanol, Isopropanol) pour améliorer la conductivité de la deuxième couche interfaciale 213 et 223.

### Cas des substrats flexibles :

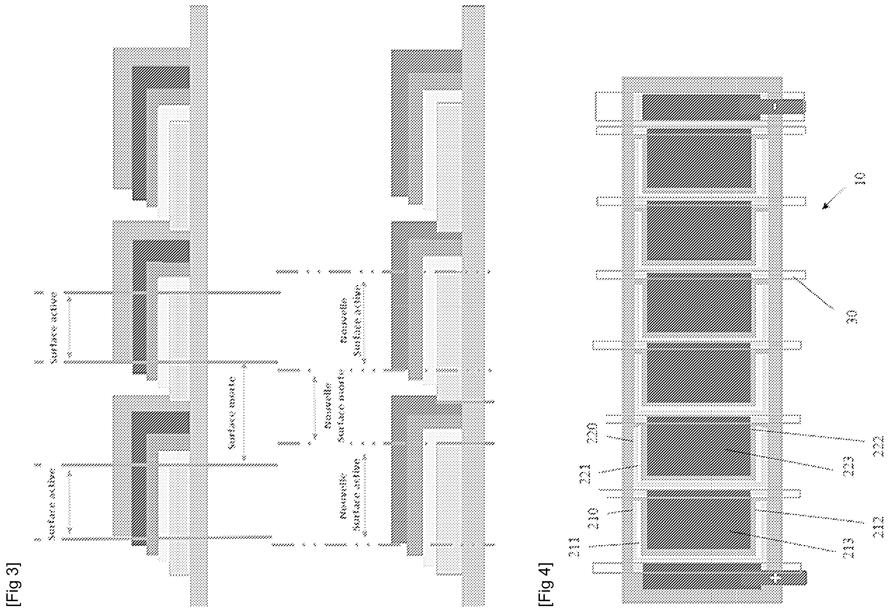

- Le substrat ITO/PET est protégé par deux films en plastique sur les deux faces:
   ∘ on colle ce substrat avec du scotch double face sur une lame de verre ayant la même dimension ;
   ∘ On enlève ensuite le film plastique qui couvre la face ITO du substrat ;
- Impression de l'encre E11 (ou E12) sur chacune des couches d'oxyde d'indium-étain 210 et 220 suivi d'un recuit à 85 °C pendant 5 minutes pour obtenir la première couche interfaciale 211 et 221;
- Impression de l'encre E21 ou E22 sur chacune des premières couches interfaciales 211 et 221 suivi d'un recuit à 85 °C pendant 2 minutes pour obtenir la couche active 212 et 222 ;
- Nettoyage de la couche active 212 et 222 avec un alcool (Ethanol, Butanol, isopropanol) ;
- Impression de l'encre E31 ou E32 sur chacune des couches actives 212 et 222 suivi d'un recuit à 120 °C pendant 2 minutes de manière à avoir une deuxième couche interfaciale 213 et 223 présentant une épaisseur comprise entre 100 et 400 nm, en particulier environ égale à 350 nm, la deuxième couche interfaciale 213 de la première cellule photovoltaïque 21 étant en contact (contact désigné par la référence 30 dans la figure 4) avec la couche d'oxyde d'indium-étain 220 de la deuxième cellule photovoltaïque 22 ;
- Nettoyage de la couche E31 ou E32 avec un alcool (Ethanol, Butanol, isopropanol);
- Détacher le module photovoltaïque ainsi obtenue du film en plastique.

On obtient, à l'issue du procédé de fabrication, un module photovoltaïque 10 comprenant les cellules photovoltaïques organiques 21 et 22 suivantes, qui sont récapitulées dans le tableau 4 ci-après et qui comprennent alors une deuxième couche interfaciale 213 et 223 comme anode qui présente une structure fibreuse organique micrométrique.

**[Table 4]**

| Cellules OPV selon l'invention | Composition de la première couche interfaciale 211 et 221 | Composition de la couche active photovoltaïque 212 et 222 | Nettoyage couche active | Composition de la deuxième couche interfaciale 213 et 223 | Nettoyage de la couche interfaciale |
|---|---|---|---|---|---|
| C1 | E11 | E21 | Oui | E31 | oui |
| C2 | E12 | E21 | Oui | E31 | oui |
| C3 | E11 | E22 | Oui | E31 | oui |
| C4 | E12 | E22 | Oui | E31 | oui |
| C5 | E11 | E21 | Oui | E32 | oui |
| C6 | E12 | E21 | Oui | E32 | oui |
| C7 | E11 | E22 | Oui | E32 | oui |
| C8 | E12 | E22 | Oui | E32 | oui |

### EXEMPLE 7 : obtention d'exemples de modules conformes à l'art antérieur/témoins

On réalise des modules photovoltaïques comprenant des cellules OPV conformes à l'art antérieur/témoins selon le procédé suivant :
1) Les substrats ITO (achetés chez Lumtec^{®}, 15 Ohm sq-1) ont été soigneusement nettoyés par sonication dans l'eau déionisée l'acétone, l'éthanol puis dans l'IPA (isopropanol) (10 minutes par bain) ;
2) Une solution à base de nanoparticules de ZnO (où d'AZO) dans l'IPA et de l'éthanolamine à 0,2% (v / V) a été déposée par centrifugation (ou « *spin coating* ») à 1500 tr / min pendant 1 min et séchées à 80 ° C pendant 5 min sur plaque chauffante ;
3) PTB7-Th (ou PV2000) et PC70BM sont mélangés avec un rapport massique de 1: 1.5 dans l'o-xylène comme solvant et la tétraline comme additif avec une concentration de 10 mg/ml en polymère (le ratio entre solvant et additif est 97 :3 v/v). Une couche ayant une épaisseur nominale de 90-100 nm, a été déposée par centrifugation (ou « *spin coating* ») à 2 700 tr / min pendant 2 min ;
4) Une couche fine de poly (3,4-PEDOT: PSS) (S315) a été déposée par centrifugation (ou « *spin coating* ») sur la couche organique à la vitesse de 3000 tr / min pendant 60 s, puis chauffée sur une plaque chauffante à 120 ° C pendant 5 minutes ;
5) Pour l'anode, des échantillons ont été placés dans un évaporateur MBRAUN à l'intérieur d'une boîte à gants, dans lequel des électrodes métalliques Al (100 nm) ont été évaporées thermiquement sous une pression de 2 x 10-7 Torr à travers un masque.
6) élaboration d'un module photovoltaïque comprenant de telles cellules photovoltaïques organiques et dans lequel l'anode d'une cellule photovoltaïque adjacente à une autre est en contact avec la couche d'oxyde d'indium-étain de cette dernière pour garantir le contact ohmique entre chacune des cellules photovoltaïques organiques du module photovoltaïque.

Il est à noter par ailleurs que la figure 3 illustre le gain en surface active et la perte en surface morte du module selon un mode particulier selon l'invention (module située en partie inférieure de la figure 3) par rapport à un module de l'état actuel de la technique (module située en partie supérieure de la figure 3) qui comprend comme anode une couche métallique par exemple appliquée sur une deuxième couche interfaciale 213 et 223 elle-même appliqué sur une couche active 212 et 222.

### EXEMPLE 8 : caractérisation des cellules OPV obtenues aux exemples 6 et 7

Les différents modules photovoltaïques comprenant les cellules OPV, selon l'invention ont été caractérisées selon les tests indiqués précédemment et les résultats de ces caractérisations dans le tableau 5 ci-après.

**[Table 5]**

| Cellules OPV selon l'invention | Intensité lumineuse en lux | Irradiance en mW/cm² | Facteur de remplissage en % | Rendement en % |
|---|---|---|---|---|
| C1 | 1000 | 0.3 | 68 | 16.5 |
| C2 | 1000 | 0.3 | 72 | 18.2 |
| C3 | 1000 | 0.3 | 69 | 16.9 |
| C4 | 1000 | 0.3 | 73 | 20.1 |
| C5 | 1000 | 0.3 | 64 | 14.5 |
| C6 | 1000 | 0.3 | 70 | 15.6 |
| C7 | 1000 | 0.3 | 65 | 14.7 |
| C8 | 1000 | 0.3 | 71 | 16.1 |

Les cellules OPV selon l'invention C1 à C8 montrent que la problématique d'impression de la couche à la fois ETL (acronyme anglais pour « electron transport layer » : couche de transport d'électrons) et anode en matériau PEDOT-PSS, d'une cellule photovoltaïque est résolu. En particulier, de telles cellules sont avantageuses lorsqu'elles sont soumises à un faible rayonnement, en particulier à un rayonnement intérieur. On est ainsi en mesure de réaliser un module photovoltaïque 10 comprenant plusieurs cellules photovoltaïques organiques 21 et 22 composées chacune de 3 couches imprimées sur une première électrode transparente conductrice présente sur le substrat souple plastique ou rigide verre, ou composée de 4 couches imprimées sur un substrat souple plastique ou rigide verre vierge de tout matériaux.

L'invention consiste à formuler une solution de PEDOT-PSS compatible avec le procédé d'impression jet d'encre et qui présente des caractéristiques de conductivité électrique notamment suffisante pour s'affranchir de l'application sur la deuxième couche interfaciale d'une anode de sorte que la deuxième couche interfaciale soit elle-même l'anode. Cette formulation nous permet de mettre en œuvre avantageusement un PEDOT-PSS de haute conductivité classiquement utilisé en couche HTL (acronyme anglais pour « hole transport layer » : couche de transport de trous), pour obtenir une couche à la fois ETL et anode.

Le procédé d'impression jet d'encre combiné à cette formulation nous permet de contrôler l'épaisseur de couche imprimée, pour optimiser les caractéristiques électriques et optiques du matériau, mais aussi de la structure de la deuxième couche interfaciale avec la réalisation d'une structure cristalline amorphe fibreuse organique, présentant en particulier des fibres organiques essentiellement orientées sensiblement verticalement pour favoriser le transport des charges. Les rendements de conversion des modules réalisés à l'aide de la présente invention restent uniques à ce jour.

### COMPARAISON :

Aussi, un module photovoltaïque Margent a été fabriqué. Ce module Margent comprend plusieurs cellules C1 ci-avant indiquées sur lesquelles ont en outre été appliquée une anode à base d'argent ayant une épaisseur de l'ordre de 120 nm une résistivité électrique de l'ordre de 2.5 µΩ.cm comme indiqué sur la figure du bas de la figure 3. La cellule comprenant de l'argent est désignée par Cargent et a été caractérisée selon les tests indiqués précédemment et les résultats de ces caractérisations dans le tableau 6 ci-après.

**[Table 6]**

| | Intensité lumineuse en lux | Tension en circuit ouvert (en V) | Intensité de court-circuit (en µA) | Tension max générée par le module (en V) | Intensité max générée par le module (en µA) | Puissance max générée par le module (en µW) | Facteur de remplissage (en %) |
|---|---|---|---|---|---|---|---|
| Cargent | 200 | 2.41 | 23 | 1.78 | 11.21 | 19.9 | 36 |
| | 500 | 2.68 | 73 | 2.36 | 32.33 | 76.29 | 39 |
| | 1000 | 3.11 | 157 | 2.45 | 87.6 | 214.62 | 44 |
| | 5 000 | 4.21 | 1780 | 3.02 | 1191 | 3596.82 | 48 |
| | 10 000 | 4.42 | 4100 | 3.13 | 3068.5 | 9604.4 | 53 |
| | 100 000 (equivalent à AM 1.5) | 4.69 | 31400 | 4.175 | 20450 | 85378.75 | 58 |

En guise de comparaison, un module photovoltaïque M1 selon l'invention et comprenant plusieurs cellules photovoltaïques C1 citées ci-avant a été fabriqué. La cellule C1 (sans argent) a été caractérisée selon les tests indiqués précédemment et les résultats de ces caractérisations dans le tableau 7 ci-après.

**[Table 7]**

| | Intensité lumineuse en lux | Tension en circuit ouvert (en V) | Intensité de court-circuit (en µA) | Tension max générée par le module (en V) | Intensité max générée par le module (en µA) | Puissance max générée par le module (en µW) | Facteur de remplissage (en %) |
|---|---|---|---|---|---|---|---|
| C1 | 200 | 3.475 | 57 | 2.75 | 48.2 | 132.5 | 67 |
| | 500 | 3.675 | 140 | 3.00 | 116.6 | 349.8 | 68 |
| | 1000 | 3.825 | 258 | 3.00 | 223.6 | 661.2 | 68 |
| | 5 000 | 4.125 | 1374 | 2.90 | 1074 | 3114.6 | 55 |
| | 10 000 | 4.275 | 2849 | 2.850 | 2008 | 5722.8 | 47 |
| | 100 000 (equivalent à AM 1.5) | 4.575 | 6950 | 2.73 | 4278 | 11764.5 | 37 |

A l'aide de ces deux tableaux (tables 6 et 7), on constate bien que le comportement de chaque module Margent et MC1 sera très différent avec ces cellules Cargent et C1 qui présentent des performances photovoltaïques différentes comme indiqué ci-après.

En effet, pour la structure utilisant PEDOT :PSS comme électrode (C1), les facteurs de remplissage sont considérablement meilleurs dans le cas de faible rayonnement (inférieur à 1000 Lux) ce qui se traduit par une facilité d'extraction de charges et d'un faible taux de recombinaison de ces dernières. Dans ce cas, les valeurs de tensions en circuit ouvert ainsi que les courants de courts circuits sont considérablement meilleures que ceux obtenues avec les cellules Cargent utilisant la couche d'argent dans les mêmes conditions d'éclairage (rayonnement inférieur à 1000 Lux).

Par ailleurs, les performances photovoltaïques du module M1 (structure sans argent) comprenant les cellules C1 se dégradent continument en augmentant le niveau d'éclairage (rayonnement lumineux) et deviennent très basses sous le spectre solaire AM 1.5 (100 mW/cm2) ce qui prouve les limites d'utilisation de cette structure (efficacité uniquement dans des conditions intérieures).

Il est à noter également que les performances photovoltaïques obtenues dans le cas de la structure Margent comprenant les cellules Cargent évoluent, quant à elles, d'une façon inverse (en fonction du rayonnement lumineux auxquelles les cellules sont exposées) à ceux obtenus avec M1 comprenant les cellules C1. En effet, au-delà de 1000 lux, les performances photovoltaïques obtenues avec la structure Margent s'améliorent pour atteindre un maximum à 100 mW/cm².

Ceci s'explique par le fait que le nombre de charges photo-générées dans les conditions intérieures (rayonnement inférieur ou égal à 1000 lux) est très faible et donc ne nécessite pas une électrode de haute conductivité pour assurer leur collecte. Dans ce cas, la couche PEDOT :PSS est capable d'assurer la fonction d'électrode dans les cellules C1 de la structure M1. Dans le cas d'un éclairage plus important (rayonnement supérieur à 1000 lux) la couche PEDOT : PSS ne peut pas transporter et collecter tous les charges photo-générées ce qui provoque une accumulation des charges au niveau de cette couche et par la suite une dégradation des facteurs de remplissage.

La couche d'argent des cellules Cargent est, quant à elle, capable d'assurer la collecte d'un grand nombre de charge du fait de sa haute conductivité en comparaison avec celle du PEDOT :PSS. La perte de charges au niveau de l'interface PEDOT :PSS/couche d'argent dans les cellules Cargent a moins d'impact sur les performances photovoltaïques dans le cas d'un éclairage important (rayonnement supérieur à 1000 lux selon lequel le nombre de charges photo-générées est très important) mais cela devient plus pénalisant dans le cas d'un éclairage intérieure (rayonnement inférieur ou égal à 1000 lux selon lequel le nombre de charges photo-générées est très faible) ce qui explique la dégradation des performances du module Margent exposé à rayonnement inférieur ou égal à 1000 lux.

### LISTE DES REFERENCES

[1] Sharaf Sumaiya, Kamran Kardel, and Adel El-Shahat. "Organic Solar Cell by Inkjet Printing - An Overview." 53, Georgia, USA : Technologies, 2017, Vol. 5.
[2] Peng, X., Yuan, J., Shen, S., Gao, M., Chesman, A. S. R., & Yin, H. (2017). "Perovskite and Organic Solar Cells Fabricated by Inkjet Printing: Progress and Prospects", Adv. Funct. Mater. 2017, 1703704
[3] Demande de brevet Européen EP2960957 de DRACULA TECHNOLOGIES, déposée le 25 juin 2015 et publiée le 30 décembre 2015.
[4] Maisch, P., Tam, K. C., Lucera, L., Egelhaaf, H. J., Scheiber, H., Maier, E., & Brabec, C. J. (2016). "Inkjet printed silver nanowire percolation networks as electrodes for highly efficient semitransparent organic solar cells". Organic Electronics: Physics, Materials, Applications, 38, 139-143. https://doi.org/10.1016/j.orgel.2016.08.006.

## Revendications

1. Module photovoltaïque (10) comprenant :
• un support (20) en verre ou en un matériau polymère,
• au moins deux cellules photovoltaïques (21, 22), une première cellule photovoltaïque (21) et une deuxième cellule photovoltaïque (22), sur ledit support (20), chacune desdites deux cellules photovoltaïques (21, 22) comprenant :
i. une couche d'oxyde d'indium-étain (210, 220) constituant la cathode et recouvrant ledit support (20),
ii. une première couche interfaciale (211, 221) d'oxyde de zinc ou d'oxyde de zinc dopé à l'aluminium, ladite première couche interfaciale (211, 221) recouvrant ladite cathode (210, 220),
iii. une couche active photovoltaïque (212, 222) recouvrant ladite première couche interfaciale (211, 221), et
iv. une deuxième couche interfaciale (213, 223) comprenant un mélange polymère de poly(3,4-éthylènedioxythiophène) et de poly(styrène-sulfonate) de sodium, ladite deuxième couche interfaciale (213, 223) constituant l'anode et recouvrant ladite couche active photovoltaïque (212, 222), ladite deuxième couche interfaciale (213, 223 ) étant continue, présentant une structure fibreuse organique et une épaisseur moyenne comprise entre 100 nm et 400 nm,
la deuxième couche interfaciale (213) de la première cellule photovoltaïque (21) étant en contact avec la couche d'oxyde d'indium-étain (220) de la deuxième cellule photovoltaïque (22).

2. Module photovoltaïque (10) selon la revendication 1, selon lequel lesdites deuxièmes couches interfaciales (213, 223) présentent une résistance carrée comprise entre 100 Ω/□ et 600 Ω/□.

3. Module photovoltaïque (10) selon l'une des revendications 1 ou 2, selon lequel lesdites deuxièmes couches interfaciales (213, 223) présentent une rugosité Ra égale ou inférieure à 5 nm.

4. Module photovoltaïque (10) selon l'une quelconque des revendications 1 à 3, selon lequel lesdites couches actives photovoltaïques (212, 222) comprennent un mélange de polymères comprenant du [6,6]-phenyl-C₆₁-butanoate de méthyle associé à du poly(thiéno[3,4-b]-thiophène.

5. Module photovoltaïque (10) selon l'une quelconque des revendications 1 à 4, selon lequel ledit support (210) est souple.

6. Utilisation dudit module photovoltaïque (10) tel que défini selon l'une quelconque des revendications 1 à 5 sur des produits de type équipement sportif léger, poussette, packaging, notamment de luxe, bagagerie, maroquinerie, décoration intérieur, électronique, panneau publicitaire sur lieu de vente, équipement de protection individuel, ganterie, jouet et loisir éducatif, mobilier, parasol, textile, cycle, automobile.

7. Utilisation dudit module photovoltaïque (10) tel que défini selon l'une quelconque des revendications 1 à 5 sous un rayonnement égal ou inférieur à 1000 lux.

8. Procédé de fabrication d'un module photovoltaïque (10) tel que défini selon l'une quelconque des revendications 1 à 5, comprenant les étapes suivantes :
a) fourniture d'un support (20) en verre ou en un matériau polymère ;
b) réalisation sur ledit support (20) de deux couches d'oxyde d'indium-étain (210, 220), chacune desdites couches d'oxyde d'indium-étain (210, 220) constituant la cathode de chacune desdites cellules photovoltaïques (21, 22) ;
c) réalisation de deux premières couches interfaciales (211, 221), chacune desdites deux premières couches interfaciales (211, 221) étant réalisée sur chacune desdites couches d'oxyde d'indium-étain (220) ;
d) réalisation de deux couches actives photovoltaïques (212, 222), chacune desdites couches actives photovoltaïques (212, 222) étant réalisée sur chacune desdites premières couches interfaciales (211, 221) ;
e) réalisation de deux deuxièmes couches interfaciales (213, 223), chacune desdites deuxièmes couches interfaciales (213, 223) étant réalisée sur chacune desdites couches actives photovoltaïques (212, 222) et constituant l'anode de chacune desdites cellules photovoltaïques (21, 22) ;
ledit procédé étant **caractérisé en ce que** les étapes c) à e) sont chacune réalisées par dépôt de compositions d'encre par impression numérique à jet d'encre, suivie d'un traitement thermique, ladite composition d'encre utilisée dans l'étape e) comprenant un mélange polymère de poly(3,4-éthylènedioxythiophène) et de poly(styrène-sulfonate) de sodium.

9. Procédé selon la revendication 8, dans lequel on réalise entre les étapes d) et e) un nettoyage desdites couches actives photovoltaïques (212, 222) à l'aide d'un solvant choisi parmi l'éthanol, le butanol, le méthanol, l'isopropanol et l'éthylène glycol.

10. Procédé selon l'une des revendications 8 ou 9, dans lesquelles étapes c) à e) sont réalisées comme suit :
c) dépôt par impression numérique à jet d'encre sur chacune desdites deux couches d'oxyde d'indium-étain (210, 220) d'une première composition d'encre comprenant des nanoparticules d'oxyde de Zinc ou des nanoparticules d'oxyde de zinc dopé à l'aluminium (AZO), puis traitement thermique, pour former lesdites deux premières couches interfaciales (211, 221) ;
d) dépôt par impression numérique à jet d'encre sur lesdites deux premières couches interfaciales (211, 221) d'une deuxième composition d'encre comprenant un mélange de polymères comprenant du [6,6]-phenyl-C₆₁-butanoate de méthyle associé à du poly(thiénol[3,4-b]-thiophène) pour former lesdites deux couches actives photovoltaïques (212, 222) ; et
e) dépôt par impression numérique à jet d'encre sur lesdites deux couches actives photovoltaïques (212, 222) d'une troisième composition d'encre comprenant un mélange polymère de poly(3,4-éthylènedioxythiophène) et de poly(styrène-sulfonate) de sodium , puis traitement thermique, pour former lesdites deux deuxièmes couches interfaciales (213, 223).

11. Procédé selon la revendication 10, dans lequel les traitements thermiques des étapes c) à e) sont des traitements de recuit réalisés à une température comprise entre 70°C et 130°C, pendant une durée comprise entre 1 et 5 minutes.

12. Procédé selon la revendication 11, dans lequel
• le traitement thermique de l'étape c) est réalisé sur une plaque chauffante à une température de 85°C pendant 3 minutes ;
• le traitement thermique de l'étape d) est réalisé sur une plaque chauffante à une température de 85°C pendant 2 minutes ; et
• le traitement thermique de l'étape e) est réalisé sur une plaque chauffante à une température de 120°C pendant 1 à 5 minutes.

13. Procédé selon l'une quelconque des revendications 8 à 12, dans lequel l'étape b) de réalisation desdites deux couches d'oxyde d'indium-étain (220) est réalisée par dépôt sous vide.

14. Procédé selon l'une quelconque des revendications 10 à 12, dans lequel les étapes c) à e) de dépôts par impression numérique à jet d'encre sont réalisées sous atmosphères à air ambiant.

15. Procédé selon l'une quelconque des revendications 10 à 14, dans lequel l'étape e) de dépôt par impression numérique à jet d'encre d'une troisième composition d'encre est réalisée par le dépôt d'une encre présentant une viscosité inférieure à 10 mPa.s à 20°C et comprenant :
- entre 90% et 98% en volume par rapport au volume total de ladite composition d'une solution de Poly(3,4-ethylènedioxythiophene)-poly(styrènesulfonate) de sodium, et
- entre 2% et 10% en volume par rapport au volume total d'une composition d'additifs comprenant :
∘ entre 2% et 5% en volume par rapport au volume total de l'ensemble des additifs de la composition d'additifs d'un tensioactif,
∘ entre 0,8% et 2% en volume par rapport au volume total de l'ensemble des additifs de la composition d'additifs d'éthylène glycol,
∘ entre 0.4% et 1% en volume par rapport au volume total de l'ensemble des additifs de la composition d'additifs éthanolamine, et
∘ entre 0,8% et 2% en volume par rapport au volume total de l'ensemble des additifs de la composition d'additifs d'un glycérol.

## Patentansprüche

1. Photovoltaikmodul (10), umfassend:
• ein Substrat (20) aus Glas oder einem Polymermaterial,
• mindestens zwei Photovoltaikzellen (21, 22), eine erste Photovoltaikzelle (21) und eine zweite Photovoltaikzelle (22), auf dem genannten Substrat (20),
wobei jede der beiden Photovoltaikzellen (21, 22) umfasst:
i. eine Kathodenschicht aus Indium-Zinn-Oxid (210, 220), die das genannte Substrat (20) bedeckt,
ii. eine erste Grenzschicht (211, 221) aus Zinkoxid oder aluminiumdotiertem Zinkoxid, wobei die erste Grenzschicht (211, 221) die genannte Kathode (210, 220) bedeckt,
iii. eine photovoltaisch aktive Schicht (212, 222), die die genannte erste Grenzschicht (211, 221) bedeckt, und
iv. eine zweite Grenzschicht (213, 223), umfassend eine Polymermischung aus Poly(3,4-ethylendioxythiophen) und Natrium-Poly(styrensulfonat), wobei die zweite Grenzschicht (213, 223) die Anode bildet und die genannte photovoltaisch aktive Schicht (212, 222) bedeckt, wobei die zweite Grenzschicht (213, 223) kontinuierlich ist, eine organische faserige Struktur aufweist und eine mittlere Dicke zwischen 100 nm und 400 nm hat,
wobei die zweite Grenzschicht (213) der ersten Photovoltaikzelle (21) in Kontakt mit der Indium-Zinn-Oxid-Schicht (220) der zweiten Photovoltaikzelle (22) steht.

2. Photovoltaikmodul (10) nach Anspruch 1, **dadurch gekennzeichnet, dass** die genannten zweiten Grenzschichten (213, 223) einen Flächenwiderstand zwischen 100 Ω/□ und 600 Ω/□ aufweisen.

3. Photovoltaikmodul (10) nach einem der Ansprüche 1 oder 2, **dadurch gekennzeichnet, dass** die genannten zweiten Grenzschichten (213, 223) eine Rauheit Ra von höchstens 5 nm aufweisen.

4. Photovoltaikmodul (10) nach einem der Ansprüche 1 bis 3, **dadurch gekennzeichnet, dass** die genannten photovoltaisch aktiven Schichten (212, 222) eine Polymermischung umfassen, die Methyl-[6,6]-phenyl-C61-butanoat in Kombination mit Poly(thieno[3,4-b]-thiophen) enthält.

5. Photovoltaikmodul (10) nach einem der Ansprüche 1 bis 4, **dadurch gekennzeichnet, dass** das genannte Substrat (210) flexibel ist.

6. Verwendung des genannten Photovoltaikmoduls (10) gemäß einem der Ansprüche 1 bis 5 auf Produkten wie Leichtsportausrüstung, Kinderwagen, Verpackungen, insbesondere Luxusverpackungen, Gepäck, Lederwaren, Inneneinrichtungen, Elektronik, Werbetafeln am Verkaufsort, persönliche Schutzausrüstung, Handschuhe, Spielzeug und Edutainment, Möbel, Sonnenschirme, Textilien, Fahrräder und Automobile.

7. Verwendung des genannten Photovoltaikmoduls (10) gemäß einem der Ansprüche 1 bis 5 unter Strahlung von höchstens 1000 Lux.

8. Verfahren zur Herstellung eines Photovoltaikmoduls (10) gemäß einem der Ansprüche 1 bis 5, umfassend die folgenden Schritte:
a) Bereitstellen eines Substrats (20) aus Glas oder einem Polymermaterial;
b) Bilden zweier Indium-Zinn-Oxid-Schichten (210, 220) auf dem genannten Substrat (20), wobei beide Indium-Zinn-Oxid-Schichten (210, 220) die Kathode jeder der genannten Photovoltaikzellen (21, 22) darstellen;
c) Bilden zweier erster Grenzschichten (211, 221), wobei beide ersten Grenzschichten (211, 221) jeweils auf den genannten Indium-Zinn-Oxid-Schichten (220) gebildet werden;
d) Bilden zweier photovoltaisch aktiver Schichten (212, 222), wobei beide photovoltaisch aktiven Schichten (212, 222) jeweils auf den genannten ersten Grenzschichten (211, 221) gebildet werden;
e) Bilden zweier zweiter Grenzschichten (213, 223), wobei beide zweiten Grenzschichten (213, 223) jeweils auf den genannten photovoltaisch aktiven Schichten (212, 222) gebildet werden und die Anode jeder der genannten Photovoltaikzellen (21, 22) darstellen;
wobei sich das Verfahren **dadurch gekennzeichnet, dass** die Schritte c) bis e) jeweils durch Aufbringen von Tintenformulierungen mittels digitalem Inkjet-Druck, gefolgt von einer Wärmebehandlung, durchgeführt werden, wobei die in Schritt e) verwendete Tintenformulierung eine Polymermischung aus Poly(3,4-ethylendioxythiophen) und Natrium-Poly(styrensulfonat) umfasst.

9. Verfahren nach Anspruch 8, **dadurch gekennzeichnet, dass** zwischen den Schritten d) und e) eine Reinigung der genannten photovoltaisch aktiven Schichten (212, 222) mit einem Lösungsmittel durchgeführt wird, das aus Ethanol, Butanol, Methanol, Isopropanol und Ethylenglykol ausgewählt ist.

10. Verfahren nach einem der Ansprüche 8 oder 9, wobei die Schritte c) bis e) wie folgt durchgeführt werden.
c) Aufbringen mittels digitalem Inkjet-Druck auf jede der beiden Indium-Zinn-Oxid-Schichten (210, 220) einer ersten Tintenformulierung, die Zinkoxid-Nanopartikel oder aluminiumdotierte Zinkoxid-Nanopartikel (AZO) umfasst, gefolgt von einer Wärmebehandlung, um die beiden ersten Grenzschichten (211, 221) zu bilden;
d) Aufbringen mittels digitalem Inkjet-Druck auf die genannten beiden ersten Grenzschichten (211, 221) einer zweiten Tintenformulierung, die eine Polymermischung umfassend Methyl-[6,6]-phenyl-C61-butanoat in Kombination mit Poly(thieno[3,4-b]-thiophen) enthält, um die beiden photovoltaisch aktiven Schichten (212, 222) zu bilden; und
e) Aufbringen mittels digitalem Inkjet-Druck auf die genannten beiden photovoltaisch aktiven Schichten (212, 222) einer dritten Tintenformulierung, die eine Polymermischung aus Poly(3,4-ethylendioxythiophen) und Natrium-Poly(styrensulfonat) umfasst, gefolgt von einer Wärmebehandlung, um die beiden zweiten Grenzschichten (213, 223) zu bilden.

11. Verfahren nach Anspruch 10, **dadurch gekennzeichnet, dass** die Wärmebehandlungen der Schritte c) bis e) Glühbehandlungen sind, die bei einer Temperatur zwischen 70 °C und 130 °C für eine Dauer zwischen 1 und 5 Minuten durchgeführt werden.

12. Verfahren nach Anspruch 11, **dadurch gekennzeichnet, dass**
• die Wärmebehandlung von Schritt c) auf einer Heizplatte bei einer Temperatur von 85 °C für 3 Minuten durchgeführt wird;
• die Wärmebehandlung von Schritt d) auf einer Heizplatte bei einer Temperatur von 85 °C für 2 Minuten durchgeführt wird; und
• die Wärmebehandlung von Schritt e) auf einer Heizplatte bei einer Temperatur von 120 °C für 1 bis 5 Minuten durchgeführt wird.

13. Verfahren nach einem der Ansprüche 8 bis 12, **dadurch gekennzeichnet, dass** Schritt b) des Bildens der beiden Indium-Zinn-Oxid-Schichten (220) durch Vakuumabscheidung durchgeführt wird.

14. Verfahren nach einem der Ansprüche 10 bis 12, **dadurch gekennzeichnet, dass** die Schritte c) bis e) der Abscheidung mittels digitalem Inkjet-Druck unter Umgebungsatmosphäre durchgeführt werden.

15. Verfahren nach einem der Ansprüche 10 bis 14, **dadurch gekennzeichnet, dass** Schritt e) des Aufbringens mittels digitalem Inkjet-Druck einer dritten Tintenformulierung dadurch durchgeführt wird, dass eine Tinte abgeschieden wird, die eine Viskosität von weniger als 10 mPa·s bei 20 °C aufweist und umfasst:
- zwischen 90 % und 98 % Volumen, bezogen auf das Gesamtvolumen der genannten Zusammensetzung, einer Lösung aus Natrium-Poly(3,4-ethylendioxythiophen)-Poly(styrensulfonat), und
- zwischen 2 % und 10 % Volumen, bezogen auf das Gesamtvolumen, einer Additivzusammensetzung, umfassend:
∘ zwischen 2 % und 5 % Volumen, bezogen auf das Gesamtvolumen aller Additive in der Additivzusammensetzung, eines Tensids,
∘ zwischen 0,8 % und 2 % Volumen, bezogen auf das Gesamtvolumen aller Additive in der Additivzusammensetzung, Ethylenglykol,
∘ zwischen 0,4 % und 1 % Volumen, bezogen auf das Gesamtvolumen aller Additive in der Additivzusammensetzung, Ethanolamin, und
∘ zwischen 0,8 % und 2 % Volumen, bezogen auf das Gesamtvolumen aller Additive in der Additivzusammensetzung, Glycerin.

## Claims

1. A photovoltaic module (10) comprising:
• a substrate (20) made of glass or a polymer material,
• at least two photovoltaic cells (21, 22), a first photovoltaic cell (21) and a second photovoltaic cell (22), on said substrate (20), each of said two photovoltaic cells (21, 22) comprising:
i. a cathode layer of indium-tin oxide (210, 220) covering said substrate (20),
ii. a first interfacial layer (211, 221) of zinc oxide or aluminum-doped zinc oxide, said first interfacial layer (211, 221) covering said cathode (210, 220),
iii. a photovoltaic active layer (212, 222) covering said first interfacial layer (211, 221), and
iv. a second interfacial layer (213, 223) comprising a polymer blend of poly(3,4-ethylenedioxythiophene) and sodium poly(styrene sulfonate), said second interfacial layer (213, 223) constituting the anode and covering said photovoltaic active layer (212, 222), said second interfacial layer (213, 223) being continuous, having an organic fibrous structure and an average thickness of between 100 nm and 400 nm, the second interfacial layer (213) of the first photovoltaic cell (21) being in contact with the indium-tin oxide layer (220) of the second photovoltaic cell (22).

2. The photovoltaic module (10) according to claim 1, wherein said second interfacial layers (213, 223) have a square resistance between 100 Ω/□ and 600 Ω/□.

3. The photovoltaic module (10) according to one of claims 1 or 2, wherein said second interfacial layers (213, 223) have a roughness Ra equal to or less than 5 nm.

4. The photovoltaic module (10) according to any one of claims 1 to 3, wherein said photovoltaic active layers (212, 222) comprise a polymer blend comprising methyl [6,6]-phenyl-C₆₁-butanoate associated with poly(thieno[3,4-b]-thiophene.

5. The photovoltaic module (10) according to any one of claims 1 to 4, wherein said substrate (210) is flexible.

6. The use of said photovoltaic module (10) as defined according to any one of claims 1 to 5 on products such as light sports equipment, strollers, packaging, particularly luxury packaging, luggage, leather goods, interior decor, electronics, point-of-sale advertising panels, personal protective equipment, gloves, toys and edutainment, furniture, sunshades, textiles, bicycles and automobiles.

7. The use of said photovoltaic module (10) as defined according to any one of claims 1 to 5 under radiation equal to or less than 1000 lux.

8. A method of manufacturing a photovoltaic module (10) as defined in any one of claims 1 to 5, comprising the following steps:
a) providing a substrate (20) made of glass or a polymer material;
b) forming two indium-tin oxide layers (210, 220) on said substrate (20), both of said indium-tin oxide layers (210, 220) constituting the cathode of each of said photovoltaic cells (21, 22);
c) forming two first interfacial layers (211, 221), both of said two first interfacial layers (211, 221) being formed on each of said indium-tin oxide layers (220);
d) forming two active photovoltaic layers (212, 222), both of said photovoltaic active layers (212, 222) being formed on each of said first interfacial layers (211, 221);
e) forming two second interfacial layers (213, 223), both of said second interfacial layers (213, 223) being formed on each of said photovoltaic active layers (212, 222) and constituting the anode of each of said photovoltaic cells (21, 22);
said method being **characterized in that** steps c) through e) are each performed by depositing ink compositions by digital inkjet printing followed by heat treatment, said ink composition used in step e) comprising a polymer blend of poly(3,4-ethylenedioxythiophene) and sodium poly(styrene sulfonate).

9. The method according to claim 8, wherein a cleaning of said photovoltaic active layers (212, 222) is performed between steps d) and e) using a solvent selected from ethanol, butanol, methanol, isopropanol and ethylene glycol.

10. The method according to one of claims 8 or 9, wherein steps c) to e) are performed as follows:
c) depositing by digital inkjet printing on each of the two indium-tin oxide layers (210, 220) a first ink composition comprising zinc oxide nanoparticles or aluminum-doped zinc oxide (AZO) nanoparticles, followed by heat treatment, to form the first two interfacial layers (211, 221);
d) depositing by digital inkjet printing on said first two interfacial layers (211, 221) a second ink composition comprising a polymer blend comprising methyl [6,6]-phenyl-C₆₁-butanoate combined with poly(thienol[3,4-b]-thiophene) to form said two photovoltaic active layers (212, 222); and
e) depositing by digital inkjet printing on said two photovoltaic active layers (212, 222) a third ink composition comprising a polymer blend of poly(3,4-ethylenedioxythiophene) and sodium poly(styrene sulfonate), followed by heat treatment, to form said two second interfacial layers (213, 223).

11. The method according to claim 10, wherein the heat treatments of steps c) to e) are annealing treatments carried out at a temperature between 70°C and 130°C, for a time between 1 and 5 minutes.

12. The method according to claim 11, wherein
• the heat treatment of step c) is carried out on a hot plate at a temperature of 85°C for 3 minutes;
• the heat treatment of step d) is carried out on a hot plate at a temperature of 85°C for 2 minutes; and
• the heat treatment of step e) is carried out on a hot plate at a temperature of 120°C for 1 to 5 minutes.

13. The method according to any one of claims 8 to 12, wherein step b) of making said two indium-tin oxide layers (220) is performed by vacuum deposition.

14. The method according to any one of claims 10 to 12, wherein steps c) to e) of digital inkjet printing deposition are performed under ambient air atmospheres.

15. The method according to any one of claims 10 to 14, wherein step e) of depositing by digital inkjet printing a third ink composition is performed by depositing an ink having a viscosity of less than 10 mPa.s at 20°C and comprising:
- between 90% and 98% by volume, relative to the total volume of said composition, of a solution of sodium poly(3,4-ethylenedioxythiophene)-poly(styrene sulfonate), and
- between 2% and 10% by volume relative to the total volume of an additive composition comprising:
∘ between 2% and 5% by volume relative to the total volume of all additives in the additive composition of a surfactant,
∘ between 0.8% and 2% by volume relative to the total volume of all additives in the ethylene glycol additive composition,
∘ between 0.4% and 1% by volume relative to the total volume of all additives in the ethanolamine additive composition, and
∘ between 0.8% and 2% by volume relative to the total volume of all additives in the additive composition of a glycerol.
